# EUROPEAN PATENT APPLICATION

(11) **EP 0 625 804 A2**
(43) Date of publication of application: **23.11.1994**
(21) Application number: 94107611.9
(22) Date of filing: 17.05.1994
(51) Int. Cl.: H01L 31/109, H01L 31/20, H01L 31/0224, H01L 31/0376

(54) **Semiconductor optical sensor and method of manufacturing it**

(30) Priority: 17.05.1993 JP 113536/93
(71) Applicant: FUJI ELECTRIC CO., LTD., Kawasaki City 210 (JP)
(72) Inventor: Ueno, Masakazu, c/o Fuji Electric Co., Ltd., Kawasaki-ku, Kawasaki 210 (JP); Sato, Noritada, c/o Fuji Electric Co., Ltd., Kawasaki-ku, Kawasaki 210 (JP); Kawakami, Haruo, c/o Fuji Electric Co., Ltd., Kawasaki-ku, Kawasaki 210 (JP)
(74) Representative: Hoffmann, Eckart, Dipl.-Ing.

(57) **Abstract**

Described is a semiconductor optical sensor comprising an amorphous carbon layer (2) and a transparent electrode (3) on one side of a semiconductor substrate (1) and an ohmic electrode (5) on the other side of the semiconductor substrate (1) wherein a rectifying junction is formed between said carbon layer and said semiconductor substrate. The carbon layer having a relatively high resistivity substantially suppresses a leakage current otherwise occurring under reverse bias, and at the same time serves as a protective layer. A preferred method of forming the amorphous carbon layer (2) on the semiconductor substrate (1) is by decomposition of ethyl alcohol in a DC plasma CVD process.

## Description

The present invention relates to a semiconductor optical sensor or photodetector for sensing light by utilizing a photo-electric effect. The invention also relates to a manufacturing method.

Currently, Si photodiodes having PN junctions or PIN junctions are mainly used as semiconductor optical sensors in a wide variety of industrial applications. In these cases the junction is formed by diffusing impurities into a single crystalline or polycrystalline substrate or by successively depositing amorphous silicon thin layers of different conductivity types on a substrate. On the other hand, a semiconductor optical sensor which uses a Schottky junction has the advantage that it can be more easily produced. The Schottky junction is formed, for example, by sputtering a metallic layer to a thickness of several nm on an N-type substrate. If light enters the depletion layer created by applying a reverse bias to a Schottky junction, electrons and holes are generated. The semiconductor optical sensor using a Schottky junction detects the light by accumulating the charge on the electrodes used for applying the electric field to the depletion layer.

It is known to use an amorphous carbon layer deposited by a CVD method as a semiconducting layer or an insulating layer. The document JP-A-62-188 383, for example, describes an optically excited semiconductor device which is comprised of a PN junction semiconductor layer, a transparent electrode and an amorphous carbon layer disposed between them and acting as a barrier which has an insulating property and which is used as the photosensitive element. The document JP-A-63-16675 describes a radiation sensor which uses an amorphous carbon layer as a semiconductor which generates electric charge in response to incident radiation.

The characteristics of a semiconductor optical sensor having a Schottky junction between an Au thin film electrode and an Si substrate, strongly depend on the thickness of the Au electrode and, therefore, it is necessary to accurately control the thickness of the Au electrode. When the Au thin film electrode is thicker than an optimum value, the light transmissivity is reduced and a reduction of sensitivity incurred. Conversely, when the electrode layer is too thin, the junction is incomplete, the number of generated carriers is reduced by recombination and, as a result, the leakage current increases. In any case, since the layer thickness is small, the electrode must be covered with a protective layer comprising a transparent resin. Above this, the leakage current of a reverse-biased Schottky junction is large in general which makes it difficult to make a distinction between the light sensing current and the leakage current and, as a result, a reduction in sensitivity is incurred.

It is, therefore, the object of the present invention to provide a semiconductor optical sensor which overcomes the above problems of the prior art by stabilizing the electrical characteristics and reducing the leakage current under reverse bias, and which does not require a protective layer. Another object of the invention is to provide a method of manufacturing such semiconductor optical sensor

These objects are achieved with a semiconductor optical sensor as claimed in claim 1 and a method as claimed in claim 6, respectively.

Preferred embodiments of the invention are subject-matter of the dependent claims.

In the semiconductor optical sensor according to the present invention electrons and holes which, in response to incident light, are generated in a depletion layer formed by applying a reverse bias between the transparent electrode and the ohmic electrode, are picked up as a signal corresponding to the incident light.

An amorphous carbon layer having a bandgap of 3.0 eV greater than that of standard semiconductors forms a rectifying junction when being contacted with a semiconductor substrate such as a silicon substrate. Whether this rectification is attributable to a heterojunction between the semiconductor and the amorphous carbon or to a tunnel diode effect of an MIS structure is unclear at present. However, electrons and holes are generated by light incident on a depletion layer created in the rectifying junction when a reverse bias is applied, so that such device can be used for sensing light in the same way as diodes in conventional semiconductor optical sensors. However, the mechanism for generating electrons and holes in this case is clearly different from that occurring in the prior art of JP-A-62-188 383 in response to light incident on the PN junction, and is also different from that of the document JP-A-63-16675 where electric charge is generated when the amorphous carbon layer is exposed to radiation. By using the high resistance amorphous carbon layer, the leakage current under reverse bias can be suppressed. Nevertheless, a sufficient signal current can be obtained because of the amorphous carbon layer is not a perfect insulating layer like an SiO₂ layer. Also, since the amorphous carbon layer exhibits photoconductivity in wavelength regions of 500 nm and less, the sensitivity of a semiconductor optical sensor in those regions can be increased. Further, the amorphous carbon layer also serves as a protective layer for the semiconductor substrate.

Preferred embodiments of the present invention will be described in detail below with reference to the drawings, in which:
- Fig. 1: is a cross-sectional view of an optical sensor according to a first embodiment of the present invention;
- Fig. 2: is a diagrammatic view of CVD apparatus used for forming the amorphous carbon layer in one example of the present invention;
- Fig. 3: is a graph showing the sensitivity of the optical sensor of Fig. 1 as a function of the wavelength; and
- Fig. 4: is a cross-sectional view of an optical sensor according to a second embodiment of the present invention.

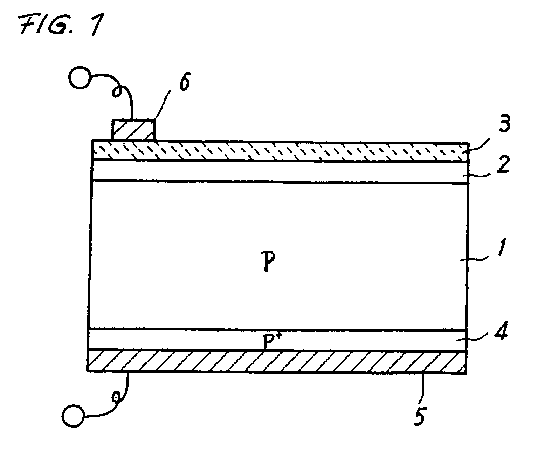

Fig. 1 is a cross-sectional view showing the structure of an optical sensor device according to a first embodiment of the present invention. Formed on the upper surface of a P-type silicon substrate 1 is an amorphous carbon layer 2 on which in turn is formed a transparent electrode layer 3. A grid-shaped metal electrode 6 for outputting a current signal is attached to the transparent electrode layer 3. On the lower surface of the silicon substrate 1 an ohmic electrode 5 is formed with a P⁺-type layer 4 between the substrate and the electrode.

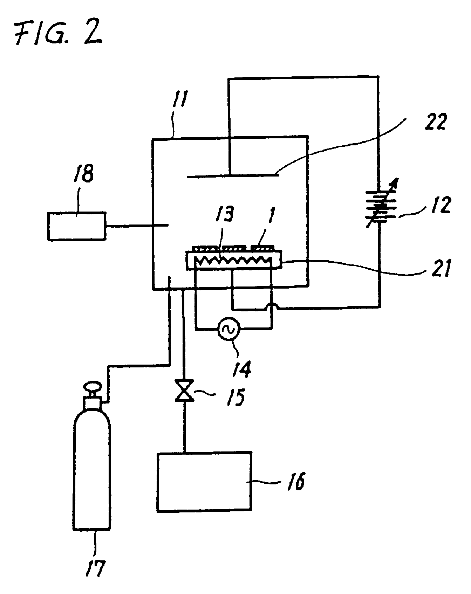

An example of an optical sensor having the structure shown in Fig. 1 was fabricated in the following way. A P-type silicon substrate having a diameter of 50 mm, a thickness of 0.5 mm and a resistivity of greater than 10 kΩ·cm was prepared. An amorphous carbon layer, approximately 20 nm thick, was then formed by decomposition of an ethyl alcohol gas by a DC (direct current) plasma CVD (chemical vapor deposition) method. The CVD apparatus used for this purpose is shown in Fig. 2. In this apparatus, an earth electrode 21 and a high voltage electrode 22 are positioned opposite to each other within a vacuum chamber 11 with both electrodes connected to a voltage source 12. A heater 13 is installed within the earth electrode 21 and connected to a power source 14. An exhaust system 16, via a vacuum valve 15, an ethyl alcohol vessel 17 and a pressure gauge 18 are connected to the vacuum chamber 11. The silicon substrate 1 was mounted on the earth electrode 21 of this apparatus. The vacuum chamber 11 was then evacuated using the exhaust system 16 down to a pressure of about 1 x 10⁻⁷ Torr (1,33 x 10⁻⁵ Pa). The vacuum valve 17 was then throttled so as to reduce the exhaust rate, while at the same time a valve for the ethyl alcohol vessel 17 was opened so as to cause a flow of 4 sccm of gaseous ethyl alcohol into the vacuum chamber whose pressure increased to 0,2 Torr (26,6 Pa). A voltage of 500 V was then applied between electrodes 21 and 22 to generate a glow discharge resulting in an amorphous carbon layer 2 being deposited on the silicon substrate 1. As the transparent electrode 3, an ITO layer was then formed on the amorphous carbon layer 2 to a thickness of 70 nm using a sputter method. As for the electrode 6 for outputting the signal, an Al layer was deposited by an evaporation method to a thickness of 100 nm onto the ITO layer 3. The Al layer was then patterned to form a 5 mm grid-shaped metal electrode 6 which was then connected to a terminal.

If the amount of incident light is to be small, so that the current generated will also be small, the grid-shaped metal electrode 6 can be omitted.

On the other hand, a boron layer was formed by DC plasma doping for ten minutes using a B₂H₆ gas and then annealed by argon plasma annealing for ten minutes, thereby forming a P⁺-type layer 4 on the opposite surface of the silicon substrate 1. A rear surface electrode 5 was formed by Al deposition thereafter.

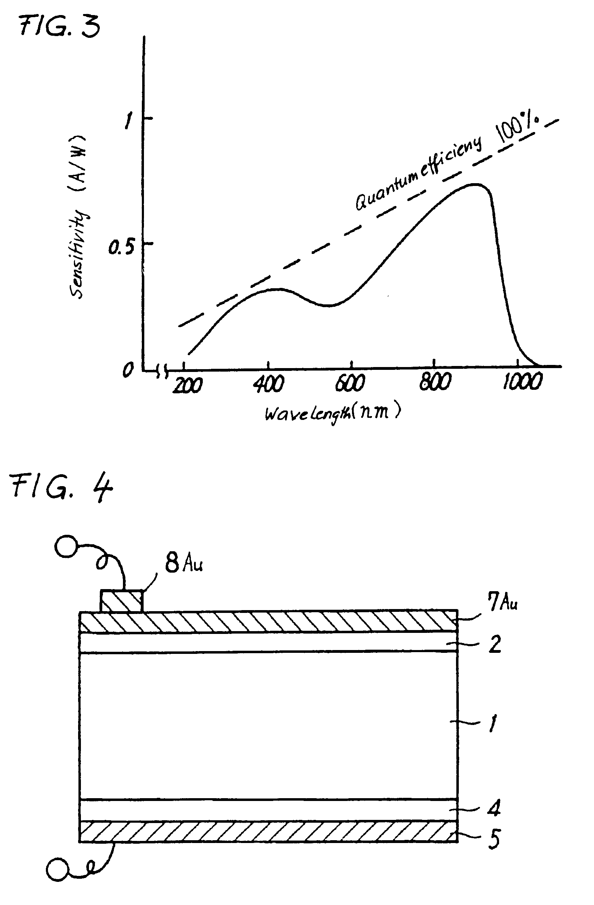

Fig. 3 shows a sensitivity curve of an optical sensor that was made in this way. Measurements were taken with a fixed energy light spectroscope having a focal length of 250 mm and a diffraction grating, irradiating light of 50 µW/cm² and changing the light wavelength. When these measurements were taken, the effective surface area of the light sensor was 25 mm² and a reverse bias of 30 V was applied. As can be seen from Fig. 3, sensitivity peaks were found to exist at wavelengths of 900 nm and 400 nm. The peak at 900 nm was caused by currents due to carriers generated within the depletion layer formed within the silicon substrate. It follows that the spectral shape of the wavelength region from 600 to 1100 nm resembles that of a conventional Si-PIN photodiode. It is also similar to the sensitivity characteristic of a Schottky junction photodiode. Namely, the sensitivity has a maximum in the region of 900 nm and the quantum efficiency gradually decreases as the wavelength becomes shorter.

The peak at around 400 nm is peculiar to this optical sensor, and carriers are generated in the amorphous carbon layer itself and, moreover, it strongly depends upon the voltage. Therefore, it becomes clear that the amorphous carbon layer itself exhibits photoconductivity. In any case, the intensity in the region of 400 nm is high with the quantum efficiency being in excess of 90 %. Further, even if the P⁺-type layer 4 is omitted, this will not affect the measurement at the time of applying the reverse bias.

The resistivity of the amorphous carbon is controlled by the film forming conditions and the hydrogen content. If the resistivity is too small, the effect of the suppression of the leakage current under reverse bias is lost. The rectification property is also lost, so that the property becomes close to an ohmic property. Therefore, a proper resistivity range is 10⁹ to 10¹¹ Ω·cm. On the other hand, if the amorphous carbon layer 2 is thicker, leakage current under reverse bias is more strongly reduced and the protection effect of the layer is also increased. However, if the layer is too thick, the depletion layer will not spread effectively into the silicon substrate 1 because the voltage drop across the carbon layer increases as the thickness of the carbon layer increases and the proportion of the reverse bias voltage that effectively creates the depletion layer decreases correspondingly. As a result of measurements with respect to the depletion layer thickness of samples having carbon layer thicknesses up to 1 µm, it was confirmed that the depletion layer spread into the whole of a silicon layer having a thickness of 0.5 mm under a reverse bias of about 40 V. However, a thickness of 2 to 100 nm is proper although the limit is 0.5 µm from the viewpoint of the detecting boundary for the signal current flowing through the carbon layer.

Fig. 4 shows an optical sensor device according to a second embodiment of the present invention. In Fig. 4, the same reference numerals are used to denote portions same as those in Fig. 1. In this embodiment, an Au thin layer electrode 7, a number of nm thick is formed on the amorphous carbon layer 2, and an Au bump 8 is also formed for bonding a wire. Here, the thickness of the Au thin layer electrode 7 is adjusted so that light of a wavelength of 400 nm can pass therethrough with substantially no attenuation. Accordingly, the quantum efficiency of the peak in the region of 400 nm is increased as compared to the embodiment shown in Fig. 1, but the 900 nm peak does not appear.

The present invention is by no means limited to the embodiments described above. It is the aim of the present invention to form an amorphous carbon layer on a substrate so as to obtain a rectifying characteristic. The basic conditions to realize the object are that the amorphous carbon layer has a bandgap larger than that of the substrate and exhibits photoconductivity. Consequently, it goes without saying that semiconductors such as Ge, GaAs, SiC and thin diamond layers can be used for the semiconductor substrate 1 and, for example, In₂O₃, SnP₂ or the like can be used instead of ITO for the transparent electrode layer 3. Also, a thin layer of Al, Cr, Mo, Ag, Ir, Nb, Ta, V, Ti, Pt, Pd, Pb, Zn, Ni or NiCr can be used in place of the Au thin layer electrode 7.

According to the present invention, by using a rectifying element made up of a semiconductor substrate and an amorphous carbon layer, the leakage current is suppressed by the high resistive amorphous carbon layer. However, since the amorphous carbon layer is not a perfect insulating layer, sufficient signal current can be obtained, and the optical sensor according to the present invention can be used for increasing the sensitivity in wavelength regions lower than 500 nm. Also, the amorphous carbon layer serves as a protective film and, therefore, the characteristics of the sensor are stable. Further, this sensor can be made by a manufacturing process which is simpler than that of the prior art.

## Claims

1. A semiconductor optical sensor comprising an amorphous carbon layer (2) and a transparent electrode (3; 7) on one side of a semiconductor substrate (1) and an ohmic electrode (5) on the other side of the semiconductor substrate (1) with a rectifying junction being formed between said carbon layer and said semiconductor substrate.

2. The sensor according to claim 1, wherein the resistivity of said amorphous carbon layer is between 10⁹ and 10¹¹ Ω·cm.

3. The sensor according to claim 1 or 2, wherein the thickness of the amorphous carbon layer (2) is less than 0.5 µm.

4. The sensor according to any one of the preceding claims, wherein said transparent electrode layer (3; 7) is an oxidized metal layer.

5. The sensor according to any one of claims 1 to 3, wherein said transparent electrode layer (3; 7) is a metallic layer of limited thickness.

6. A method of manufacturing a semiconductor optical sensor as defined in any one of the preceding claims, wherein the amorphous carbon layer (2) is formed on the semiconductor substrate (1) by decomposition of ethyl alcohol in a DC plasma CVD process.
